Europäisches Patentamt

European Patent Office

Office européen des brevets

(11) Veröffentlichungsnummer: **0 245 764**

**A1**

(12) **EUROPÄISCHE PATENTANMELDUNG**

(21) Anmeldenummer: 87106564.5

(22) Anmeldetag: 06.05.87

(51) Int. Cl.4: **C23C 14/18** , C23C 14/40 , C23C 4/00

(30) Priorität: 16.05.86 DE 3616499

(43) Veröffentlichungstag der Anmeldung: 19.11.87 Patentblatt 87/47

(84) Benannte Vertragsstaaten: AT BE CH DE ES FR GB GR IT LI LU NL SE

(71) Anmelder: **Reimbold & Strick GmbH & Co. KG Kunftstrasse 4 D-5000 Köln 91(DE)**

(72) Erfinder: **Cremer, Wilhelm, Dipl.-Ing. (FH) Vorhelmer Weg 99 D-4730 Ahlen(DE)**

(74) Vertreter: **Keller, Johanna Carola et al Deichmannhaus am Hauptbahnhof D-5000 Köln 1(DE)**

(54) **Mit Silicium elektrisch leitfähig und oxidationsbeständig beschichtete Graphit-Elektrode und Verfahren zu ihrer Herstellung.**

(57) Es wird eine Graphit-Elektrode beschrieben, deren elektrisch leitfähige und oxidationsbeständige Siliciumbeschichtung aus Siliciumwasserstoffen, Siliciumhalogenwasserstoffen oder deren Gemischen gebildet worden ist. Das Verfahren zur Herstellung dieser Graphit-Elektrode mit Siliciumbeschichtung besteht im wesentlichen darin, daß die Abscheidung des Siliciums im Niederdruckplasma-Verfahren erfolgt.

EP 0 245 764 A1

## Mit Silicium elektrisch leitfähig und oxidationsbeständig beschichtete Graphit-Elektrode und Verfahren zu ihrer Herstellung

Die Erfindung betrifft eine mit Silicium elektrisch leitfähig und oxidationsbeständig beschichtete Graphit-Elektrode für das Elektroschmelzen von Metallen und Metall-Legierungen.

Ein Verfahren zur Herstellung von mit Silicium elektrisch leitfähig und oxidationsbeständig beschichteten Graphit-Formkörpern, und zwar auch Graphit-Elektroden, beschreibt die europäische Patentanmeldung 87101925.3. Dieses Verfahren zeichnet sich durch eine Reihe von Verfahrensschritten aus, deren erfindungsgemäße Kombination überraschende, für den Fachmann nicht vorhersehbare und vor allem synergistische Wirkungen hervorrufende Effekte bei oxidationsbeständig beschichteten Graphit-Elektroden mit sich bringen; denn diese zeichnen sich durch eine hohe Dichte, Festigkeit und Leitfähigkeit aus und besitzen keine Oberflächenporen nach der Beschichtung. Es läßt sich allerdings nicht leugnen, daß das beschriebene Verfahren besondere Sorgfalt bei der Durchführung der einzelnen Verfahrensschritte erfordert, um die angestrebte Wirkung in jedem Falle zu erzielen, so daß bei der Durchführung des Verfahrens ein nicht zu vernachlässigender Zeitfaktor einkalkuliert werden muß.

Der vorliegenden Erfindung liegt nun die Aufgabe zugrunde, eine Graphit-Elektrode verfügbar zu machen, die ebenfalls mit Silicium elektrisch leitfähig und oxidationsbeständig beschichtet ist, und die gleichen Vorteile wie die oben beschriebene Graphit-Elektrode aufweist, in ihrer Herstellung aber weniger zeitaufwendig ist.

Die Lösung dieser Aufgabe ist die jeweils im kennzeichnenden Teil der Patentansprüche 1 bis 5 wiedergegebene Graphit-Elektrode. Die Herstellung dieser Elektrode kann nach dem Verfahren erfolgen, das Gegenstand der Ansprüche 6 bis 14 ist.

Das geschilderte Niedruck-Plasma-Verfahren unter Einsatz eines Plasmas aus Siliciumwasserstoffen und/oder Siliciumhalogenwasserstoffen ist in besonderem Maße geeignet, porenfreie Silicium-Beschichtungen auf den Graphit-Elektroden hervorzurufen. Die Durchführung dieses Verfahrens kann in den üblichen Anlagen des Handels erfolgen, wobei die Gestaltung einer geeigneten Anlage einschließlich der erforderlichen Hochvakuumpumpenkombination dem Fachmann keine Schwierigkeit bereitet. In diesem Zusammenhang kann beispielsweise verwiesen werden auf den Aufsatz von Dr. Guido Bell "Chemische und physikalische Reaktionen im Niederuckplasma" in CHEMISCHE RUNDSCHAU, 37. Jahrg., Nr. 36 vom 05.Sept. 1984.

Bei der Durchführung des Verfahrens gemäß der Erfindung ist es vorteilhaft, die Oberfläche der zunächst mechanisch gereinigten Graphit-Electrode in der Verfahrenskammer zusätzlich zu reinigen, indem man ein Sauerstoff-Plasma einwirken läßt. Hierbei kann die Reaktionszeit durch Mitverwendung einer Halogenquelle im Plasma deutlich herabgesetzt werden. Neben Tetrafluorkohlenstoff $CF_4$ hat sich für diesen Zweck auch Schwefelhexafluorid $SF_6$ bewährt. An diese Ätzbehandlung - schließt sich dann zweckmäßig ein Absputtern der Oberfläche mit einem Edelgas-Plasma, beispielsweise einem Argon-Plasma an, mit dem eine weitere Reinigung der Elektrodenoberfläche erreicht wird.

Bei de eigentlichen Beschichtung der Elektrode mit Silicium bei einem Arbeitsdruck im Bereich von ca. 130 bis 400 µbar, sollte das Plasma aus den siliciumhaltigen Verbindungen so schwach eingestellt sein, daß in der Plasmawolke gerade noch kein Zerfall dieser Siliciumverbindungen stattfindet, sondern erst beim thermischen Kontakt mit der durch Gleichstrom aufgeheizten Graphit-Elektrode. Um eventuell zunächst nur schwach an die Oberfläche der Graphit-Elektrode gebundene Siliciumatome abzusputtern, kann die Beschichtung auch mit einem Plasmagemisch von Siliciumverbindungen und Argon oder einem anderen Edelgas durchgeführt werden.

Die Mitabscheidung von Dotierungselementen bereitet erfindungsgemäß keinerlei Schwierigkeiten; denn neben den Siliciumverbindungen können beispielsweise auch Borane oder Phosphane in geringen Mengen im Plasma Verwendung finden.

Die erfindungsgemäß erhaltenen Graphitelektroden zeichnen sich durch besondere Vorteile aus, die nachstehend augeführt sind:

1. Die Silicium-Beschichtungen sind thermisch bis nahezu 1500 °C belastbar.

2. Die Silicium-Beschichtungen sind fest, d.h. stoßfest mit dem Trägermaterial verbunden, so daß der Transport der beschichteten Elektroden vom Herstellungs-zum Einsatzort ohne Schwierigkeiten möglich ist.

3. Die Impermeabilität der Silicium-Beschichtungen ist bei thermischer Belastung bis ca. 1500 °C gesichert, so daß keine Sauerstoffunterwanderung möglich ist und sich somit auch keine großflächigen Beschichtungteile beim Erwärmen von der Elektrode ablösen.

4. Das Wärmeausdehnungsverhalten des Siliciums ist dem des Elektro-Graphits außerordentlich ähnlich, so daß beim praktischen Einsatz der beschichteten Graphit-Elektroden höchstens geringfügige Scherkräfte auftreten können, die aber nicht zum Ablösen von Beschichtungsteilen führen.

5. Die Silicium-Beschichtungen sind elektrisch leitend, so daß der bisher bei unbeschichteten Elektroden übliche elektrische Strom mit ca. 50.000 A über die Kupferklemmbacken auf die beschichteten Elektroden gegeben werden kann. Hierbei wird der Stromdurchgang von der Kupferklemmbacke durch die Siliciumbeschichtung hindurch in die Elektrode nicht wesentlich durch Stromverluste beeinträchtigt. Das Beschichtungsmaterial verkrustet nicht an der Kupferklemmbacke und verschmilzt insbesondere nicht mit dem Kupfer. Es können somit auch keine Kupferverluste auftreten; außerdem können keine Fehler in der Siliciumbeschichtung unterhalb der Klemmbacke auftreten, sobald die Elektrode entsprechend dem Abbrand der Elektrodenspitze im Lichtbogen nachgeschoben wird.

Beispiel

Eine Graphitelektrode von 2 m Länge und 60 cm Durchmesser, die in dem Fachmann bekannter Weise gefertigt worden war, wurde auf einer Drehbank abgedreht, wobei durch einen Drehstahl mit geeignet geformter Drehfläche eine feinrauhe Oberfläche erzeugt wurde. Bei diesem Abdrehvorgang entstand lose an der Elektrodenoberfläche anhaftender Graphitstaub, der im allgemeinen das Aufbringen einer oxidationsbeständigen Schicht stört, da diese nur unzureichend an der Elektrode verankert wird. Erfindungsgemäß wurde deshalb dieser lose anhaftende Graphitstaub durch Sandstrahlen der Elektrodenoberfläche mit Korund oder Stahlsand entfernt. Zusätzliche Sicherheit in bezug auf die Entfernung loser Partikel von der feinrauhen Elektrodenoberfläche wurde durch Abblasen der Partikel mit Kohlendioxid als Inertgas erreicht.

In der Zwischenzeit wurde die evakuierbare Verfahrenskammer mit Argon gespült, um vorhandenen Sauerstoff und Wasserdampf zu entfernen, und anschließend evakuiert. Diese Verfahrenskammer stand sowohl an ihrem Einlaß als auch an ihrem Auslaß mit einer weiteren evakuierbaren Kammer und diese jeweils mit einer Schleuse in Verbindung, im die Elektrode unter Vakuumbedingungen in die Verfahrenskammer hinein-und aus dieser herausbringen zu können.

Die in der oben geschilderten Weise vorbehandelte Elektrode wurde zunächst durch die Einlaßschleuse über die Zufuhröffnung in die Vakuumvorkammer eingeführt, die nach dem Schließen der gennanten Zufuhröffnung auf das Vakuum der Verfahrenskammer abgesaugt wurde. Daraufhin wurde die Verbindungsöffnung zur Verfahrenskammer geöffnet und die Elektrode in diese Verfahrenskammer überführt, um dort gemäß dem Verfahren der Erfindung aufgeheizt und mit dem Plasma von Siliciumwasserstoff SiH₄ unter Bildung einer Siliciumschicht auf dem Graphit behandelt zu werden. Anstelle von SiH₄ könnten auch höhere Silane sowie Halogensilane, wie Tri-und Dichlorsilane, und Gemische aus den gennanten Verbindungen als Plasma zur Andwendung kommen.

Bei der Durchführung des Verfahrens wurde festgestellt, daß die aufgebrachte Siliciumschicht auf dem Graphit besonders widerstandsfähig gegenüber Abreib war und auch bei gröberer mechanischer Beanspruchung besonders fest haftete, wenn a) durch die Einwirkung eines Sauerstoff/Halogenquelle-Plasmas, vor dem Zünden des Plasmas die Graphitoberfläche angeätzt wurde, und wenn b) zusätzlich mit Argon als Edelgas abgesputtert wurde. Hierbei wurde durch sorgfältiges kontinuierliches Absaugen der Verfahrenskammer mit einer der Fachwelt bekannten Kombination von Vakuumpumpen der Arbeitsdruck von etwa 300 µbar in der Verfahrenskammer so weit wie möglich konstant gehalten.

Die Graphit-Elektrode war an ihren Enden während ihrer Beschichtung in der Verfahrenskammer über Stromanschlüsse direkt mit dem Generator verbunden und somit als Hochfrequenzelektrode geschaltet, während die Verfahrenskammer die Gegenelektrode darstellte. Auf diese Weise konnte die Elektrode unmittelbar aufgeheizt und das Verfahren bei hohen Temperaturen an der Elektrode selbst ausgeübt werden. Temperaturen selbst im Bereich von 600 °C und darüber verursachten bei der gleichzei tigen Vakuumanwendung in der Verfahrenskammer keine unerwünschten Veränderungen der für die Siliciumbeschichtung vorbehandelten Elektrodenoberfläche.

Nach dem Erreichen einer Schichtdicke des aufgebrachten Siliciums von ca. 1 bis 5 µm wurde die der Verfahrenskammer benachbarte Austrittskammer evakuiert, worauf die beschichtete Elektrode über die Verbindungsöffnung in die evakuierte Austrittskammer überführt wurde. Deren Vakuum wurde dann durch Fluten mittels Inertgas unter gleichzeitiger Abkühlung der siliciumbeschichteten Graphit-Elektrode aufgehoben, so daß die Elektrode schließlich durch die Auslaßschleuse aus der Plasma-Vorrichtung ausgefahren und weiter abgekühlt werden konnte.

Ansprüche

1. Mit Silicium elektrisch leitfähig und oxidationsbeständig beschichtete Graphit-Elektrode für das Elektroschmelzen von Metallen und Metall-Legierungen, dadurch gekennzeichnet, daß die Siliciumbeschichtung aus Siliciumwasserstoffen und/oder Siliciumhalogenwasserstoffen gebildet worden ist.

2. Graphit-Elektrode nach Anspruch 1, dadurch gekennzeichnet, daß die Siliciumbeschichtung aus $SiH_4$ und/oder seinen höheren Homologen $Si_n H_{2n+2}$ mit $n = 2$ bis 4 gebildet worden ist.

3. Graphite-Elektrode nach Anpruch 1, dadurch gekennzeichnet, daß die Siliciumbeschichtung aus $SiHCl_3$ und/oder $SiH_2Cl_2$ gebildet worden ist.

4. Graphit-Elektrode nach Anspruch 1 bis 3, dadurch gekennzeichnet, daß die Siliciumbeschichtung Dotierungselemente, vorzugsweise Bor und/oder Phosphor enthält.

5. Graphit-Elektrode nach Anspruch 4, dadurch gekennzeichnet, daß die Dotierungselemente aus ihren Wasserstoff-Verbindungen gebildet worden sind.

6. Verfahren zur Herstellung einer mit Silicium elektrisch leitfähig und oxidationsbeständig beschichteten Graphit-Elektrode nach Anspruch 1 bis 5, wobei in an sich bekannter Weise

    a) die Graphit-Elektrode abgedreht und dabei gegebenenfalls gleichzeitig kalibriert,

    b) die abgedrehte Elektrode sandgestrahlt und

    c) gegebenenfalls mittels Inertgas von Reststaub und/oder Elektrodenpartikeln abgeblasen wird,

dadurch gekennzeichnet, daß die vorbehandelte, in die durch Spülen mit Inertgas von Sauerstoff und Wasserdampf befreite evakuierbare Verfahrenskammer einer Niederdruckplasma-Anlage eingebrachte Graphit-Elektrode durch direkte Verbindung mit dem Generator als Hochfrequenzelektrode geschaltet und nach dem Evakuieren der die Gegenelektrode bildenden Verfahrenskammer und nach dem Aufheizen mit einem Plasma von Siliciumwasserstoffen und/oder Siliciumhalogenwasserstoffen, das gegebenenfalls Borane und/oder Phosphane, enthält, behandelt und nach der Siliciumbeschichtung mit Inertgas gekühlt wird.

7. Verfahren nach Anspruch 6, dadurch gekennzeichnet, daß als Plasma ein $SiH_4$-Plasma und/oder Chlorsilan-Plasma angewandt wird.

8. Verfahren nach Anspruch 7, dadurch gekennzeichnet, daß Gemische aus Tri-und Dichlorsilanen als Plasma verwendet werden.

9. Verfahren nach den Ansprüchen 6 bis 8, dadurch gekennzeichnet, daß die Graphit-Elektrode vor der Einwirkung des siliciumhaltigen Plasmas mit einem Sauerstoff/Halogenquelle-Plasma angeätzt wird.

10. Verfahren nach Anspruch 9, dadurch gekennzeichnet, daß als Halogenquelle $CF_4$ und/oder $SF_6$ vewendet wird.

11. Verfahren nach den Ansprüchen 6 bis 10, dadurch gekennzeichnet, daß vor und/oder während der Einwirkung des siliciumhaltigen Plasmas mit einem Edelgas-Plasmas abgesputtert wird.

12. Verfahren nach Anspruch 11, dadurch gekennzeichnet, daß als Edelgas Argon verwendet wird.

13. Verfahren nach den Ansprüchen 6 bis 12, dadurch gekennzeichnet, daß im Temperaturbereich von 250 °C bis 900 °C, vorzugsweise von 300 °C bis 600 °C gearbeitet wird.

14. Verfahren nach den Ansprüchen 6 bis 13, dadurch gekennzeichnet, daß der Arbeitsdruck in der Verfahrenskammer 130 bis 400 $\mu$bar beträgt.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US - A - 3 925 577 (E.G. FATZER et al.)<br><br>* Ansprüche; Spalte 1, Zeilen 59, 60 *<br><br>-- | 1,6 | C 23 C 14/.18<br><br>C 23 C 14/40<br><br>C 23 C 4/00 |
| X | PATENT ABSTRACTS OF JAPAN, unexamined applications, C Field, Vol. 8, No. 77, 10. April 1984<br><br>THE PATENT OFFICE JAPANESE GOVERNMENT<br>Seite 106 C 218<br><br>* Kokai-No. 59-1 673 (TOKYO SHIBAURA DENKI K.K.) *<br><br>---- | 1,6-8 | |

RECHERCHIERTE
SACHGEBIETE (Int. Cl.4)

C 23 C

C 22 B

C 25 C

Der vorliegende Recherchenbericht wurde für alle Patentansprüche erstellt.

| Recherchenort | Abschlußdatum der Recherche | Prüfer |
|---|---|---|
| WIEN | 21-07-1987 | SLAMA |